# EUROPÄISCHE PATENTANMELDUNG

(11) **EP 2 533 302 A2**
(43) Veröffentlichungstag der Anmeldung: **12.12.2012**
(21) Anmeldenummer: 12163537.9
(22) Anmeldetag: 10.04.2012
(51) Int. Cl.: H01L 31/05

(54) **Solarmodul und Photovoltaik-Anlage**

(30) Priorität: 08.06.2011 DE 102011077227
(71) Anmelder: ROBERT BOSCH GMBH, 70442 Stuttgart (DE)
(72) Erfinder: Buettner, Thomas, 07745 Jena (DE)

(57) **Zusammenfassung**

Solarmodul, mit einer Mehrzahl von zu einem Strang verschalteten Solarzellen und von außen zugänglichen Strang-Anschlüssen, wobei die Strang-Anschlüsse und zwei Erdungskontakte als mechanisch fest in das Solarmodul eingefügte Steckkontakte ausgebildet und die Erdungskontakte über je eine in das Solarmodul integrierte Erdungsleitung angeschlossen sind.

## Beschreibung

Die Erfindung betrifft ein Solarmodul mit einer Mehrzahl von zu einem Strang verschalteten Solarzellen und von außen zugänglichen Strang-Anschlüssen. Des Weiteren betrifft sie eine Photovoltaik-Anlage, die eine Mehrzahl von Solarmodulen elektrisch miteinander verbunden umfasst.

### Stand der Technik

Photovoltaikmodule (PV-Module), vielfach auch Solarmodule genannt, beinhalten Solarzellen bzw. photoelektrisch aktive Schichten, welche Licht in elektrischen Strom wandeln. Diese besitzen Möglichkeiten zur elektrischen Kontaktierung, um die gewonnene elektrische Energie abzuführen bzw. um mehrere PV-Module zu einer größeren Anordnung zu verschalten. Dazu haben die PV-Module üblicherweise eine Anschlussdose.

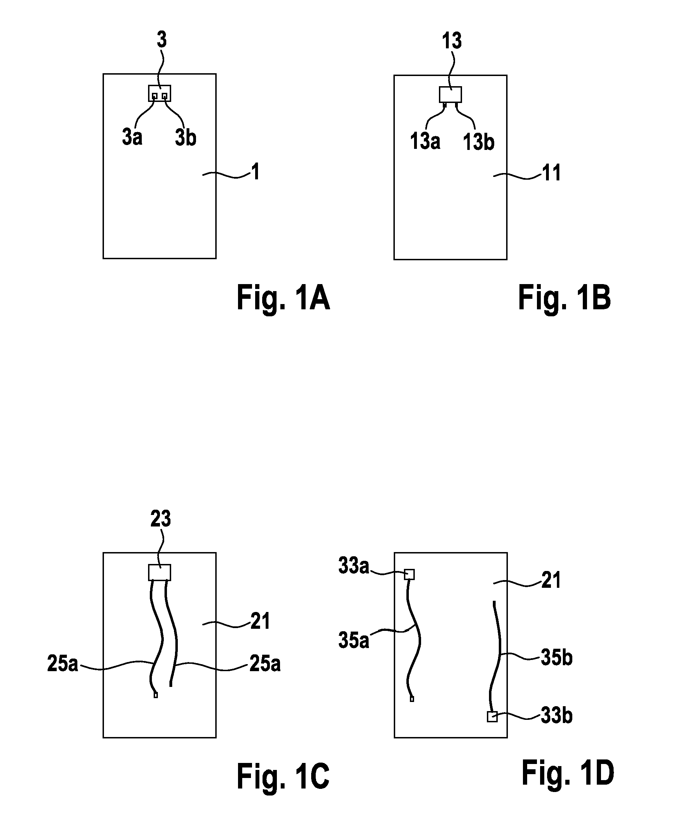

In Fig. 1A bis 1D sind verschiedene übliche Anschlussdosen- bzw. Kabel-Konfigurationen schematisch dargestellt. Fig. 1A zeigt schematisch eine Anschlussdose **3** mit zwei Anschlusskontakten **3a** und **3b** auf einem Solarmodul **1.** Fig. 1B zeigt skizzenhaft eine modifizierte Anschlussdose **13,** die zwei außen angebrachte Steckerteile bzw. Buchsen **13a**, **13b** zum Anschluss von Stromleitungen aufweist, auf einem Solarmodul **11.** Fig. 1C zeigt ein Solarmodul **21** mit einer Anschlussdose **23**, mit der fest zwei Anschlusskabel **25a**, **25b** verbunden sind, welche an ihrem jeweiligen Ende einen (nicht gesondert bezeichneten) Stecker bzw. eine Buchse haben. Fig. 1D schließlich zeigt ein Solarmodul **31** mit zwei Anschlussdosen **33a**, **33b**, mit denen jeweils ein Anschlusskabel **35a**, **35b** verbunden ist, welches an seinem Ende wiederum einen (nicht gesondert bezeichneten) Stecker bzw. eine Buchse trägt.

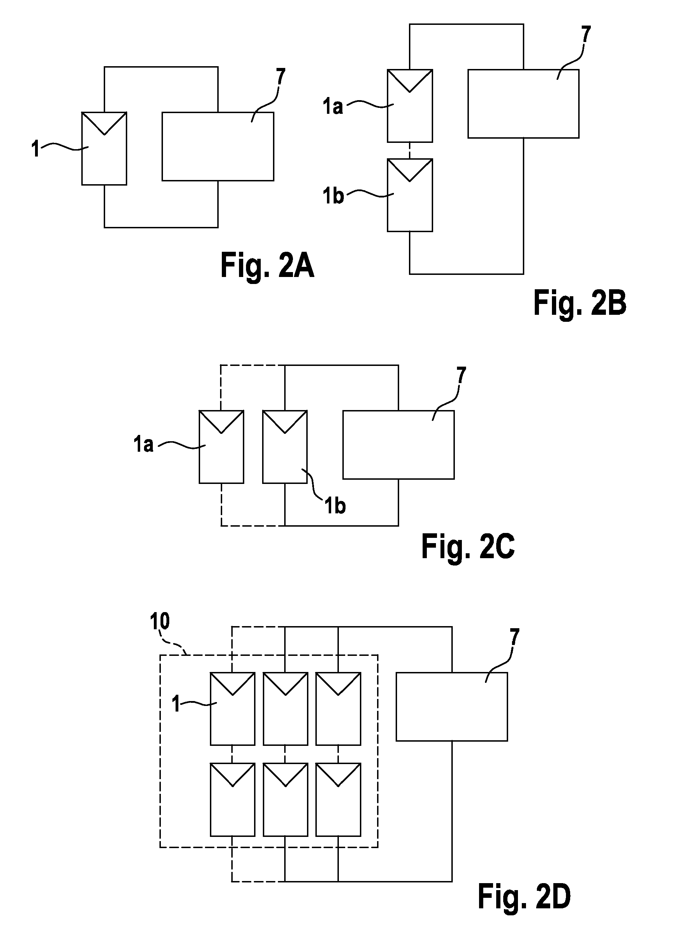

Die Fig. 2A bis 2D zeigen in Art von Blockschaltbildern verschiedene Möglichkeiten der Verschaltung von Solarmodulen mit einer Last, also einem Verbraucher oder Energiespeicher oder einer Netzeinspeisung. Fig. 2A zeigt die direkte Verschaltung eines einzelnen Solarmoduls **1** mit einer Last **7,** Fig. 2B die Serien schaltung zweier Solarmodule **1a** und **1b** mit einer Last **7,** Fig. 2C die Parallelschaltung zweier Solarmodule **1a** und **1b** mit einer Last **7** und Fig. 2D eine gemischte Serien- und Parallelschaltung von sechs Solarmodulen **1,** die zusammen eine Photovoltaik-Anlage **10** bilden, mit einer Last **7.**

### Offenbarung der Erfindung

Mit der Erfindung wird ein Solarmodul mit den Merkmalen des Anspruchs 1 sowie eine Photovoltaik-Anlage mit den Merkmalen des Anspruchs 6 bereitgestellt. Zweckmäßige Fortbildungen des Erfindungsgedankens sind Gegenstand der jeweiligen abhängigen Ansprüche.

Die Erfindung schließt den Gedanken ein, vom bisher verbreiteten Konzept des Vorsehens einer separaten Anschlussdose auf dem Solarmodul abzugehen und die Strang-Anschlüsse als Steckkontakte fest in das eigentliche Modul einzufügen. Sie schließt weiter den Gedanken ein, in gleicher Weise zwei Erdungskontakte als Steckkontakte fest in das Solarmodul einzufügen und diese über eine gleichfalls in das Modul integrierte Erdungsleitung anzuschließen.

In einer Ausführung der Erfindung ist vorgesehen, dass jeweils ein Abschnitt der Erdungsleitungen durch ein metallisches Rahmenteil des Solarmoduls gebildet ist.

In einer weiteren Ausführung ist in das Solarmodul eine Bypassleitung mit je einem von außen zugänglichen Bypass-Anschluss an ihren beiden Enden integriert.

Eine weitere Ausführung der Erfindung sieht vor, dass jeweils einer der Strang-Anschlüsse, Erdungskontakte und Bypass-Anschlüsse als männlicher Steckkontakt und der jeweils andere als weiblicher Steckkontakt ausgebildet ist.

In einer noch weiteren zweckmäßigen Ausführung weist, die Erdungs- und Bypassleitung je einen band- oder drahtförmigen Leiter auf, der in eine Einhüllung, insbesondere eine Folien-Laminierung, des Solarmoduls mit eingehüllt ist.

Die vorgeschlagene Photovoltaik-Anlage zeichnet sich dadurch aus, dass mindestes ein Teil der elektrischen Verbindungen zwischen den Solarmodulen oder mit einem Wechselrichter der Anlage oder nach außen durch Steckverbindungen gebildet ist.

In einer Ausführung der Erfindung gemäß diesem Aspekt hat die Anlage ein erstes Verbinderstück, welches zur elektrischen Verbindung eines Stranganschlusses mit einem Bypass-Anschluss ein und desselben Solarmoduls ausgebildet ist. In einer hiermit kombinierbaren, aber auch unabhängig realisierbaren weiteren Ausführung hat die Anlage ein zweites Verbinderstück, welches zur elektrischen Verbindung je eines Strang-Anschlusses und Erdungskontaktes und optional je eines Bypass-Anschlusses zweier in Reihe geschalteter Solarmodule ausgebildet ist.

Eine Ausgestaltung der die beiden letztgenannten Aspekte kombinierenden Ausführung sieht vor, dass das erste und/oder zweite Verbinderstück als im Wesentlichen starres Kunststoffteil mit mindestens je einem eingebetteten Leiter und je einem an die Anschlüsse des Solarmoduls angepassten Verbinder-Anschluss an den Enden des jeweiligen Leiters ausgebildet ist.

Bei einer weiteren zweckmäßigen Ausgestaltung ist das zweite Verbinderstück als langgestreckte Stromschiene zur elektrischen Verbindung und gleichzeitig Halterung mehrerer Solarmodule ausgebildet.

Unter Nutzung der Erfindung können Solarmodule ohne die sonst notwendigen separaten Kabel miteinander elektrisch verbunden werden. Damit ist es möglich, besonders sichere und einfache Installationen auszuführen. Es müssen keine Kabel, Stecker, Buchen o. a. kontaktiert bzw. konfektioniert werden. Ein gravierender Vorteil dieser Art der Kontaktierung ist die Möglichkeit die Funktionserdung von Modul zu Modul weiterzuleiten. Der bevorzugt eingebundene zusätzliche Bypass im Modul fungiert als Rückleiter, und ermöglichen so eine komplett kabellose Montage ermöglichen.

Das Stromschienensystem gemäß einer oben erwähnten Ausgestaltung ist flexibel für verschiedene Konfigurationen erweiterbar. Durch eine Poka Yoke Auslegung der Steckverbindung kann eine Falschpolung vermieden werden. Weiterhin kann die Erdung vom Potentialausgleich des Gebäudes über das Stecksystem an alle Module weitergereicht werden.

Dieses System bietet weiterhin den Vorteil, dass nur noch mit einem Kabel mit entsprechendem Einzeladerquerschnitt zum Wechselrichter/Verbraucher/Batterieladesystem gegangen werden muss. So braucht z. B. die PV-Anlage nur mit einem dreipoligen Kabel angeschlossen worden. Wären etwa 24 Module jeweils einzeln angeschlossen, müssten 24 Einzelkabel verwendet werden. Die Isolation dieser 24 Kabel bedingt einen hohen Platzbedarf, der durch ein einziges Kabel mit drei entsprechend großen Leiterquerschnitten stark verringert werden könnte.

Ein Stromschiensystem im Baukastencharakter lässt bevorzugt eine Verbindung von Modulen nur so zu, das in jedem Fall die Systemspannung kleiner 120V DC ist. Dies begrenzt die Anzahl der in Serie verschalteten Module. Somit besitzt die gesamte Anlage eine Systemspannung kleiner 120V DC. Bis 120V Gleichspannung spricht man von Schutzkleinspannung, diese gilt nicht als lebensgefährlich, wenn spannungsführende Teile berührt werden. Somit kann von einer solchen Anlage keine Gefährdung durch einen elektrischen Stromschlag ausgehen. Dies ist ein besonders wichtiges Thema zum Schutz von Feuerwehrleuten im Brand bzw. Havariefall.

### Zeichnungen

Weitere Vorteile und vorteilhafte Ausgestaltungen der erfindungsgemäßen Gegenstände werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen:
- Fig. 1A bis 1D: skizzenartige Darstellungen bekannter Anschlussmöglichkeiten von Solarmodulen über Anschlussdosen,
- Fig. 2A bis 2D: verschiedene praxisübliche Verschaltungsmöglichkeiten von Solarmodulen,
- Fig. 3: eine schematische Darstellung eines Solarmoduls gemäß einer Ausführung der Erfindung,
- Fig. 4: eine perspektivische Darstellung eines Solarmoduls gemäß dieser Ausführung der Erfindung,
- Fig. 5: eine perspektivische Darstellung eines Verbinderstücks und des angrenzenden Bereichs eines Solarmoduls gemäß einer weiteren Ausführung der Erfindung,
- Fig. 6: eine schematische Darstellung zur Erläuterung der Funktion dieses Verbinderstücks,
- Fig. 7: eine perspektivische Darstellung eines Verbinderstücks und des angrenzenden Bereichs eines Solarmoduls gemäß einer weiteren Ausführung der Erfindung,
- Fig. 8: eine schematische Darstellung zur Erläuterung der Funktion dieses Verbinderstücks,
- Fig. 9: eine perspektivische Darstellung der benachbarten Kantenbereiche zweier in einer Serienschaltung bei einem Indachsystem zu verschaltender Solarmodule mit einem Verbindungsprofil und

- Fig. 10: eine schematische Darstellung zur Erläuterung des Aufbaus einer weiteren Photovoltaik-Anlage.

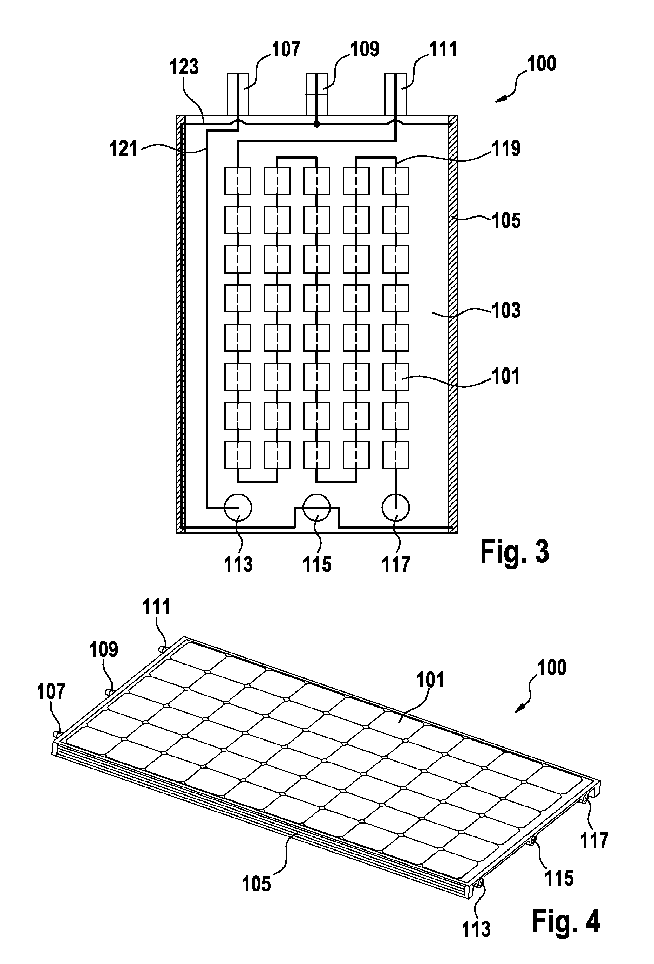

Fig. 3 zeigt schematisch, in Art einer Draufsicht, ein Solarmodul **100**, das eine Mehrzahl von Solarzellen **101** auf einem Substrat **103** aufweist und zwei leitfähige Rahmenprofile **105** hat. An einer der beiden kurzen Kanten des Solarmoduls **100** sind nebeneinander drei Stecker **107** bis **111** vorgesehen, und zwar ein Bypass-Stecker **107**, ein Erde-Stecker **109** und ein Pluspol-Stecker **111.** An der gegenüberliegenden kurzen Kante des Solarmoduls sind, in geometrisch korrespondierender Anordnung zu den erwähnten Steckern, drei Steckerbuchsen **113** bis **117** angeordnet, und zwar eine Bypass-Buchse **113**, eine Erdungskontakt-Buchse **115** und eine Minuspol-Buchse **117**. Über einen ersten Leiterzug **119** sind die Solarzellen **101** miteinander verschaltet und (über die Solarzellen) der Pluspol-Stecker **111** mit der Minuspol-Buchse **117** verbunden. Ein zweiter Leitungszug **121** verbindet direkt den Bypass-Stecker **107** mit der Bypass-Buchse **113**, und ein dritter Leitungszug **123** stellt eine Erdungsleitung dar, die unter Einbeziehung der leitfähigen Rahmenprofile **105** den Erdungsstecker **109** mit der Erdungskontakt-Buchse **115** verbindet.

Fig. 4 zeigt eine konstruktive Ausführung der Solarzelle **100** in perspektivischer Darstellung, in der die gleichen Bezugsziffern wie bei Fig. 3 zur Bezeichnung der wesentlichen Teile genutzt sind, die Leiterzüge **119** bis **123** jedoch nicht erkennbar sind.

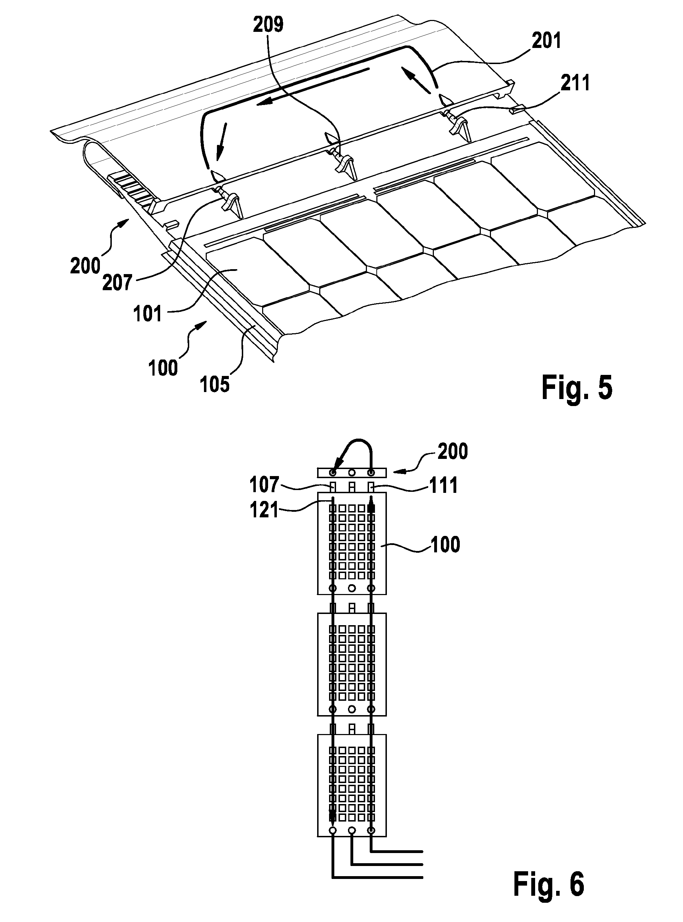

Fig. 5 zeigt in einer perspektivischen Detaildarstellung den Bereich einer kurzen Kante des Solarmoduls **100** mit einem an diese angesetzten Verbinderstück **200**, auf dem drei Steckerteile angeordnet sind, die in Anlehnung an die Wahl der Bezugsziffern in Fig. 3 hier mit den Ziffern **207**, **209** und **211** bezeichnet sind. Zwischen den äußeren Steckerteilen **207** und **211**, also einem Bypass-Steckerteil und Pluspol-Steckerteil, ist ein Verbindungskabel **201** verlegt, welches an seinen Enden zu den Steckern passende (nicht gesondert bezeichnete) Buchsen trägt. Die Figur zeigt auch ein auf das Verbinderstück **200** aufgesetztes weiteres Kunststoffteil, welches in der Figur jedoch nicht bezeichnet ist und hier nicht weiter erläutert wird, weil es nicht zur vorliegenden Erfindung gehört.

Fig. 6 zeigt schematisch die Funktion des Verbinderstücks **200** in einer Serienschaltung von drei Solarmodulen **100** als oberes Abschlussstück, nämlich die Realisierung der Serienverschaltung über die Verbindung des Pluspols des obersten Solarmoduls mit dessen integrierter Bypassleitung **121**.

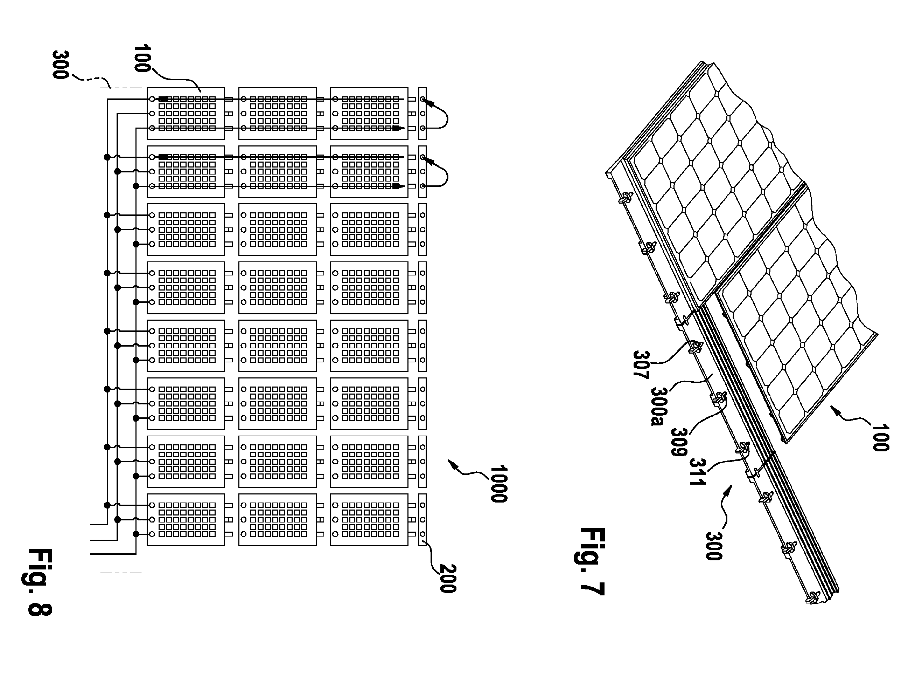

Fig. 7 zeigt in perspektivischer Darstellung die (unteren) kurzen Seiten zweier Solarmodule **100**, die in einer Photovoltaik-Anlage parallel miteinander zu verschalten sind, zusammen mit einem Verbinderstück **300**, welches als langgestrecktes Profil aus mehreren Teilabschnitten **300a** zusammengesetzt ist, von denen jedes - ähnlich wie das in Fig. 5 gezeigte Profil **200 -** ein Bypass-Steckerteil **307**, ein Erdungskontakt-Steckerteil **309** und ein Pluspol-Steckerteil **311** umfasst. Diese Steckerteile sind zum Eingriff in die (aus Gründen der besseren Übersichtlichkeit hier nicht gesondert bezeichneten) Buchsen-Teile des Solarmoduls **100** positioniert und ausgebildet.

Fig. 8 zeigt schematisch die Platzierung und innere Leitungsführung des Verbinderstücks **300** in einer Photovoltaik-Anlage **1000** aus drei Reihen von jeweils acht parallel miteinander verschalteten Solarmodulen **100**. Die rechts unten eingezeichneten Ausgänge führen zum Wechselrichter der Anlage.

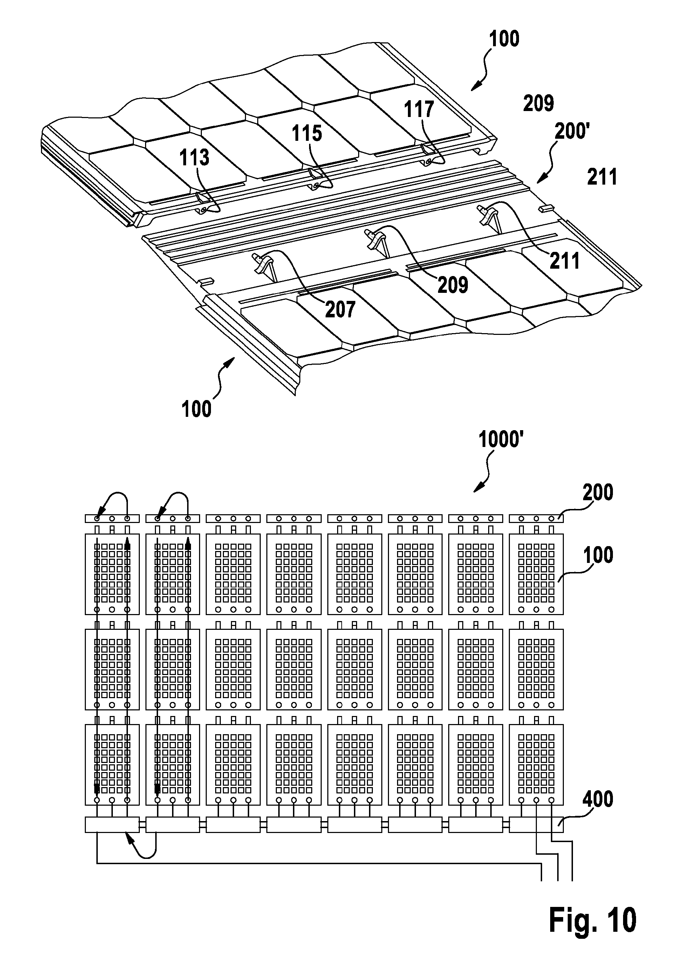

Fig. 9 zeigt, abermals in perspektivischer Detailansicht, die kurzen Seiten zweier in einer Serienschaltung miteinander zu verbindenden Solarmodule **100** zusammen mit einem gegenüber der in Fig. 5 gezeigten Ausführung modifizierten Verbinderstück **200'**, welches sich vom Verbinderstück **200** durch den Fortfall des integrierten Verbindungskabels auszeichnet. Die Steckerteile **207**, **209** und **211** greifen hier im montierten Zustand in die korrespondierend angeordneten und ausgeformten Buchsen-Teile **113**, **115** und **117** des oberen Solarmoduls ein, wodurch letztlich der Pluspol des unteren Solarmoduls mit dem Minuspol des oberen und jeweikls die Erdungsanschlüsse beider Solarmodule und deren Bypass-Anschlüsse verbunden werden.

Fig. 10 schließlich zeigt schematisch eine Photovoltaik-Anlage **1000'**, bei der sämtliche Solarmodule **100** in Reihe miteinander geschaltet sind, wobei Verbinderstücke **200** gemäß Fig. 5 und (hier nicht dargestellte) Verbinderstücke **200'** gemäß Fig. 9 neben zusätzlichen Verbinderstücken **400** eingesetzt werden können, die an der Unterkante der Anlage platziert sind und, ähnlich wie die Konfiguration nach Fig. 7, als Stromschienensystem konstruiert sein können.

Im Rahmen fachmännischen Handelns ergeben sich weitere Ausgestaltungen und Ausführungsformen des hier nur beispielhaft beschriebenen Verfahrens und der Vorrichtung.

## Patentansprüche

1. Solarmodul, mit einer Mehrzahl von zu einem Strang verschalteten Solarzellen und von außen zugänglichen Strang-Anschlüssen, wobei die Strang-Anschlüsse und zwei Erdungskontakte als mechanisch fest in das Solarmodul eingefügte Steckkontakte ausgebildet und die Erdungskontakte über je eine in das Solarmodul integrierte Erdungsleitung angeschlossen sind.

2. Solarmodul nach Anspruch 1,
wobei jeweils ein Abschnitt der Erdungsleitungen durch ein metallisches Rahmenteil des Solarmoduls gebildet ist.

3. Solarmodul nach Anspruch 2 oder 3,
wobei in das Solarmodul eine Bypassleitung mit je einem von außen zugänglichen Bypass-Anschluss an ihren beiden Enden integriert ist.

4. Solarmodul nach einem der vorangehenden Ansprüche,
wobei jeweils einer der Strang-Anschlüsse, Erdungskontakte und Bypass-Anschlüsse als männlicher Steckkontakt und der jeweils andere als weiblicher Steckkontakt ausgebildet ist.

5. Solarmodul nach einem der vorangehenden Ansprüche,
wobei die Erdungs- und Bypassleitung je einen band- oder drahtförmigen Leiter aufweist, der in eine Einhüllung, insbesondere eine Folien-Laminierung, des Solarmoduls mit eingehüllt ist.

6. Photovoltaik-Anlage, die eine Mehrzahl von Solarmodulen elektrisch miteinander verbunden umfasst,
wobei mindestes ein Teil der elektrischen Verbindungen zwischen den Solarmodulen oder mit einem Wechselrichter der Anlage oder nach außen durch Steckverbindungen gebildet ist.

7. Photovoltaik-Anlage nach Anspruch 6, mit einem ersten Verbinderstück, welches zur elektrischen Verbindung eines Stranganschlusses mit einem Bypass-Anschluss ein und desselben Solarmoduls ausgebildet ist.

8. Photovoltaik-Anlage nach Anspruch 6 oder 7, mit einem zweiten Verbinderstück, welches zur elektrischen Verbindung je eines Strang-Anschlusses und Erdungskontaktes und optional eines Bypass-Anschlusses zweiter benachbart angeordneter Solarmodule ausgebildet ist.

9. Photovoltaik-Anlage nach Ansprüche 6 bis 8,
wobei das erste und/oder zweite Verbinderstück als im Wesentlichen starres Kunststoffteil mit mindestens je einem eingebetteten Leiter und je einem an die Anschlüsse des Solarmoduls angepassten Verbinder-Anschluss an den Enden des jeweiligen Leiters ausgebildet ist.

10. Photovoltaik-Anlage nach Anspruch 9,
wobei das zweite Verbinderstück als langgestreckte Stromschiene zur elektrischen Verbindung und gleichzeitig Halterung mehrerer Solarmodule ausgebildet ist.
